(19) Europäisches Patentamt
European Patent Office
Office européen des brevets

(11) Veröffentlichungsnummer: **0 264 678 B1**

(12) # EUROPÄISCHE PATENTSCHRIFT

(45) Veröffentlichungstag der Patentschrift: **18.09.91**

(51) Int. Cl.5: **G03F 7/023**, C08G 69/26

(21) Anmeldenummer: **87114324.4**

(22) Anmeldetag: **01.10.87**

(54) **Polyamide mit Hexafluorisopropyliden-gruppen, diese enthaltende positiv arbeitende lichtempfindliche Gemische und damit hergestellte Aufzeichnungsmaterialien.**

(30) Priorität: **02.10.86 US 915342**

(43) Veröffentlichungstag der Anmeldung:
**27.04.88 Patentblatt 88/17**

(45) Bekanntmachung des Hinweises auf die Patenterteilung:
**18.09.91 Patentblatt 91/38**

(84) Benannte Vertragsstaaten:
**AT DE FR GB IT NL**

(56) Entgegenhaltungen:
**FR-A- 2 317 680**
**US-A- 3 328 352**

(73) Patentinhaber: **HOECHST CELANESE CORPORATION**
**Route 202-206 North**
**Somerville, N.J. 08876(US)**

(72) Erfinder: **Müller, Werner H., Dr.**
**22 Coveside Court**
**East Greenwich, RI 02818(US)**
Erfinder: **Hupfer, Bernd, Dr.**
**219 Pinecrest Drive**
**North Kingstown, RI 02852(US)**
Erfinder: **Khanna, Dinesh N.**
**39 Musket Avenue**
**West Warwick, RI 02893(US)**

(74) Vertreter: **Euler, Kurt Emil, Dr. et al**
**HOECHST AG - Werk KALLE Patentabteilung**
**Postfach 3540 Rheingaustrasse 190**
**W-6200 Wiesbaden(DE)**

**EP 0 264 678 B1**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Rank Xerox (UK) Business Services

## Beschreibung

Die Erfindung betrifft Polyamide mit Hexafluorisopropylidengruppen (Gruppen der Formel

$$CF_3-\overset{|}{\underset{|}{C}}-CF_3),$$

diese enthaltende positiv arbeitende lichtempfindliche hochtemperaturbeständige Gemische, im wesentlichen bestehend aus einem o-Chinondiazid und dem Polyamid mit Hexafluorisopropylidengruppen als Bindemittel.

Positiv arbeitende lichtempfindliche Gemische und ihre Verwendung sind in den US-A 3 666 473, 4 115 128 und 4 173 470 beschrieben. Bei diesen Gemischen werden als Bindemittel im allgemeinen alkalilösliche Phenolformaldehyd-Novolakharze in Verbindung mit licht-, bzw. strahlungsempfindlichen o-Chinon- oder Naphthochinondiazidverbindungen eingesetzt.

Herkömmliche positiv arbeitende lichtempfindliche Gemische auf Novolakbasis weisen unter Einwirkung erhöhter Temperaturen nur eine begrenzte Maßbeständigkeit auf und sind daher für moderne Hochtemperaturverfahren und -anwendungen schlecht geeignet. Wärmebeständige negativ arbeitende Photoresists sind bekannt und werden beispielsweise in US-A 3 957 512; 4 045 223 und 4 088 489 und in DE-A 34 11 659 (= US-A 4 622 285) beschrieben. Es sind auch wärmebeständige positiv arbeitende Photoresists bekannt, beispielsweise aus den US-A 4 093 461; 4 339 521 und 4 395 482. Zu den Vorteilen, die positiv arbeitende Resists gegenüber negativ arbeitenden Resists aufweisen, zählen u.a. ein höheres Bildauflösungsvermögen und eine längere Belichtungsbeständigkeit in Gegenwart von Sauerstoff.

Folgende Eigenschaften sind wichtig für die kommerzielle Nutzung eines Photoresists: Löslichkeit des Resists in dem jeweils verwendeten Lösemittel, Lichtempfindlichkeit, Entwicklungskontrast, Bildauflösung, Haftung des Resists auf dem Träger, Maßbeständigkeit bei erhöhten Temperaturen und Abriebfestigkeit.

Eine gute Lichtempfindlichkeit ist wichtig für einen Photoresist, insbesondere wenn er für Anwendungen eingesetzt wird, bei denen mehrere Belichtungen erforderlich sind, z. B. bei der Erzeugung von Mehrfachbildern durch ein Wiederholungsverfahren oder in Fällen, in denen Licht mit abgeschwächter Intensität verwendet wird, z. B. in der Projektionsbelichtungstechnik, bei der das Licht eine Reihe von Objektiven und monochromatischen Filtern durchläuft. Eine erhöhte Lichtempfindlichkeit ist also ganz besonders wichtig für ein Resistgemisch, das in Verfahren eingesetzt wird, bei denen Mehrfachbelichtungen durchgeführt werden müssen, um eine Maske oder eine Serie von Schaltbildern auf einem Träger zu erzeugen. Die genaue Überwachung der Lichtempfindlichkeit ist für die Erzeugung von Reliefbildern hoher Auflösung in der Mikroelektronik von größter Bedeutung, denn durch eine zu hohe Lichtempfindlichkeit könnten die Verarbeitungsbedingungen eingeschränkt werden.

Unter Auflösung des Resists versteht man die Fähigkeit eines Resistsystems zur Wiedergabe der kleinsten, im gleichen Abstand voneinander angeordneten Linienpaare und der zugehörigen Zwischenräume einer für die Belichtung verwendeten Maske, mit einem hohen Grad an Flankensteilheit des Bildes in den ausentwickelten belichteten Zwischenräumen. Für viele technische Anwendungen, insbesondere für die Herstellung von Halbleiterbauelementen in der Mikroelektronik, muß ein Photoresist einen hohen Auflösungsgrad aufweisen, wenn er sehr kleine Linien- und Zwischenraumbreiten (in der Größenordnung von l µm) wiedergeben soll.

Die Fähigkeit eines Resists zur Wiedergabe sehr kleiner Abmessungen in der Größenordnung von l µm und darunter ist bei der Herstellung von LSI-Schaltungen auf Siliziumchips und ähnlichen Bauteilen von größter Bedeutung. Die Schaltungsdichte auf einem solchen Chip kann nur durch eine Steigerung des Auflösungsvermögens des Resists erhöht werden, sofern ein photolithographischen Verfahren angewendet wird.

In der Vergangenheit wurden bereits verschiedene Versuche unternommen, um hochtemperaturbeständige Photoresists zu erhalten, die die beschriebenen erwünschten Eigenschaften aufweisen. Aus US-A 4 093 46l ist zum Beispiel ein wärmebeständiger positiv arbeitender Photoresist bekannt, der als lichtempfindliche Verbindung ein o-Chinon- oder o-Naphthochinondiazid und das Polykondensationsprodukt aus einem aromatischen Dianhydrid und einem aromatischen Diamin als Bindemittel enthält. Die Eigenschaften dieses Resists werden in US-A 4 395 482 in Spalte l, Zeilen 46 bis 64 beschrieben. Dort wird darauf hingewiesen, daß das in US-A 4 093 46l beschriebene positiv arbeitende Photoresistgemisch nur eine begrenzte Lagerfähigkeit und eine ungenügende Resistenz gegenüber Ätzalkalien besitzt sowie daß die Löslichkeitsunterschiede zwischen den belichteten und unbelichteten Resistbereichen relativ gering sind.

Daneben werden in der US-A 4 395 482 sowie in der US-A 4 339 52l positiv arbeitende Photoresistgemische beschrieben, in denen oligomere und/oder polymere Polyoxazolvorläufer in Form von Polykondensationsprodukten aromatischer und/oder heterocyclischer Dihydroxydiaminoverbindungen mit Dicarbonsäurechloriden oder -estern enthalten sind. Im einzelnen wird in den genannten Schriften ein Poly(benzidin-isophthalamid) erwähnt. Die erwähnten positiv arbeitenden Photoresistgemische sollen über gute Lagerfähigkeit, Wärmebeständigkeit, Verarbeitbarkeit und Eignung zum Einsatz in der Mikroelektronik, d.h., zur Herstellung feinstrukturierter Bilder, verfügen. Sie weisen jedoch auch einige Nachteile auf, wie geringe Löslichkeit in den üblichen Lösemitteln und eine zu geringe Lichtempfindlichkeit.

Hinzu kommt noch, daß das in Beispiel I der US-A 4 395 482 beschriebene Benzidin karzinogen und schwer herstellbar ist. Außerdem konnte festgestellt werden, daß das Poly(benzidin-isophthalamid) nach US-A 4 395 482 bei seiner Herstellung als Gel anfällt und vor seiner Isolierung vom Reaktionslösemittel abfiltriert werden muß. Als weiterer Nachteil gilt, daß auch ein lichtempfindliches Gemisch, in dem das Poly(benzidin-isophthalamid) enthalten ist, bei längerem Stehen geliert und damit keine optimale Transparenz aufweisen kann.

Hochtemperaturbeständige Polyamide mit Hexafluorisopropylidengruppen in der Polymer-Hauptkette sind auch in der US-A 3 328 352 offenbart. Doch sind hier die Hexafluorisopropylidengruppen über para-Phenylen-Brücken mit den Carboxamidogruppen verknüpft. Diese fluorhaltigen, aromatischen Polycarbonamide werden jedoch für Fasern und Folien verwendet.

Es bestand daher die Aufgabe, ein Polyamid für ein hochtemperaturbeständiges, positiv arbeitendes Gemisch mit hoher Lichtempfindlichkeit vorzuschlagen, das in organischen Lösemitteln gut löslich ist, auf dem Trägermaterial gut haftet, eine hohe Bildauflösung ermöglicht und sowohl in trockener als auch in flüssiger Form über lange Zeit gelagert werden kann. Außerdem sollen die erfindungsgemäßen lichtempfindlichen Gemische die Vorteile höherer Transparenz und geringerer Toxizität aufweisen.

Gelöst wird die Aufgabe durch Bereitstellen eines Polyamids, das als Bindemitel für positiv arbeitende lichtempfindliche Gemische geeignet ist und dadurch gekennzeichnet ist, daß es der allgemeinen Formel I

$$-\!\left[(NH-X-NH)_a-(CO-Y-CO)_b-(NH-Z-NH)_c-(CO-Y-CO)_d\right]_n- \qquad (I)$$

entspricht, worin

X eine zweiwertige Gruppe der Formel

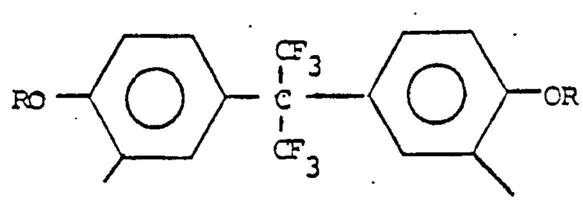

worin R gleich oder verschieden sein kann und Wasserstoff, einen ggf. substituierten aliphatischen oder aromatischen Rest mit bis zu 9 C-Atomen,

Y und Z gleich oder verschieden sind und einen ggf. substituierten aliphatischen, aromatischen oder cycloaliphatischen Rest mit bis zu 60 C-Atomen sowie Mischungen dieser,

a 0,10 bis 0,50 Molanteile,

b 0,25 bis 0,50 Molanteile,

c 0,0 bis 0,40 Molanteile und

d 0,0 bis 0,25 Molanteile, jeweils bezogen auf das Gesamtmolekulargewicht aus $X+Y+Z$, wobei $a+b+c+d=1$ gilt und

n eine ganze Zahl von 2 bis 500

bedeuten.

R besteht zu mindestens 40 Mol-%, vorzugsweise zu mindestens 60 Mol-%, aus Wasserstoff.

Das Polyamid wird durch Polykondensation beispielsweise von Hexafluor-2,2-bis(3-amino-4-hydroxyphenyl)propan mit einem zweibasischen Säurechlorid oder Gemischen zweibasischer Säurechloride hergestellt. Ein Teil des Hexafluor-2,2-bis(3-amino-4-hydroxyphenyl)propans kann durch ein anderes Diaminocomonomeres ersetzt sein, das gegebenenfalls weniger Hydroxylgruppen enthält, um die Löslichkeit des Polymeren im wäßrig-alkalischen Entwickler herabzusetzen und die Löslichkeit des Polymeren in Lösemitteln zu erhöhen. Eine andere Möglichkeit, die Löslichkeit des Polyamids im Entwickler zu senken bzw. seine

Lösemittellöslichkeit zu erhöhen, besteht darin, den Solubilisierungseffekt, den die Hydroxylgruppen im bereits hergestellten Polymeren bedingen, durch Umwandlung der Hydroxylgruppen in weniger entwicklerlösliche Gruppen zu neutralisieren, z.B., indem man einen Teil der Hydroxylgruppen des bereits gebildeten Polymeren acyliert. Durch den Einsatz von hydroxylgruppenfreien Comonomeren oder durch die Neutralisierung der Hydroxylgruppen im Anschluß an die Polykondensation ist daher die Lichtempfindlichkeit des Photoresists zu regulieren.

Die Erfindung betrifft außerdem ein positiv arbeitendes lichtempfindliches und hochtemperaturbeständiges Gemisch, dadurch gekennzeichnet, daß das Gemisch das vorstehend beschriebene erfindungsgemäße Polyamid als Bindemittel sowie ein o-Chinon-und/oder o-Naphthochinondiazid als lichtempfindliche Verbindung enthält.

Es wurde überraschend festgestellt, daß die Löslichkeit des erfindungsgemäßen Polymeren in Lösemitteln und die Lichtempfindlichkeit des erfindungsgemäßen lichtempfindlichen Gemisches reguliert werden können, indem bei der Herstellung des Polyamids ein Gemisch aus zweibasischen Säurechloriden und/oder ein Gemischaus Hexafluor-2,2-bis(3-amino-4-hydroxyphenyl)propan und einem weiteren Diamin eingesetzt werden. Für diese Zwecke besonders geeignete zweibasische Säurechloride sind Isophthaloylchlorid und Hexafluor-2,2-bis(4-chlorcarbonylphenyl)propan. Durch die Polykondensation von Isophthaloylchlorid mit Hexafluor-2,2-bis-(3-amino-4-hydroxyphenyl)propan entsteht überraschenderweise ein Polyamid, das bei Verwendung in einem positiv arbeitenden lichtempfindlichen Gemisch einen hochlichtempfindlichen Resist ergibt. Bevorzugt wird das Isophthaloylchlorid im Gemisch mit einem weiteren zweibasischen Säurechlorid verwendet und zusammen mit Hexafluor-2,2-bis(3-amino-4-hydroxyphenyl)propan polykondensiert.

Die Gemische zweibasischer Säuren enthalten dabei bevorzugt 30 bis 70 Mol-% Isophthaloylchlorid und 70 bis 30 Mol-% Terephthaloylchlorid oder Hexafluor-2,2-bis(4-chlorcarbonylphenyl)propan. Bevorzugt liegt der Anteil an Isophthaloylchlorid bei 50 Mol-%. Die Mol-%-Angaben beziehen sich jeweils auf den Gesamtgehalt des Gemisches an zweibasischem Säurechlorid.

Die Lichtempfindlichkeit der Photoresists kann beispielsweise in einem Bereich von l0 bis 300 $mJ/cm^2$ reguliert werden. Auch dies erfolgt durch eine entsprechende Zusammensetzung des Polyamids. Überraschenderweise hat es sich gezeigt, daß die Hexafluorisopropylidengruppe zu erhöhter Lichtempfindlichkeit und Lösemittellöslichkeit des Polymeren führt, wenn sie als Bindeglied in der Diaminkomponente des Polyamides fungiert, während sie zu geringerer Lichtempfindlichkeit und erhöhter Lösemittellöslichkeit führt, wenn sie im zweibasischen Säurechlorid eingesetzt wird.

Ein mit dem erfindungsgemäßen lichtempfindlichen Gemisch in herkömmlicher Weise beschichtetes und belichtetes Material kann in wäßrig-alkalischen Photoresistentwicklern zu feinstrukturierten Reliefbildern entwickelt werden, die für den Einsatz auf Gebieten der Mikroelektronik und im Druckgewerbe geeignet sind, wobei die Lichtempfindlichkeit des Photoresists den jeweiligen Erfordernissen angepaßt werden kann. Der Photoresist zeichnet sich durch eine gute Wärmebeständigkeit bis zu Temperaturen von 250 bis 350 °C, erhöhte Lichtempfindlichkeit, bessere Löslichkeit in den für Beschichtungslösungen üblichen Lösemitteln und überdurchschnittliches Haftvermögen aus.

Die vorliegende Erfindung betrifft auch ein Verfahren zur weiteren Erhöhung der Wärmebeständigkeit der erzeugten feinstrukturierten Bilder durch thermisches Aushärten des entwickelten Photoresists, wobei das Polyamid in ein Polybenzoxazol umgewandelt wird, das beständig ist gegen Temperaturen bis zu 550 °C.

Aufgrund ihrer ausgezeichneten Löslichkeit in herkömmlichen Lösemitteln, sowie ihrer guten Hafteigenschaften und Wärmebeständigkeit sind die erfindungsgemäßen Polyamide auch hervorragend zur Herstellung von wärmebeständigen Schutzüberzügen geeignet.

Besonders bevorzugt sind Polyamide der Formel I, in der

| | |
|---|---|
| a | 0,25 bis 0,5 Molanteile, |
| R | Wasserstoff, Methyl, Ethyl oder Phenyl, |
| n | eine ganze Zahl von 20 bis 300; insbesondere von 5 bis 200, |
| Y,Z | gleich oder verschieden sein können und Methylen, Difluormethylen, Polydifluormethylen mit 2 bis 12 C-Atomen, ein ggf. substituiertes Polymethylen mit 2 bis 12 C-Atomen, Cyclohexylen, Cyclohexenylen, Piperazinylen, Arylen, Biarylen, Naphthylen oder ein Polyarylen nach Formel II |

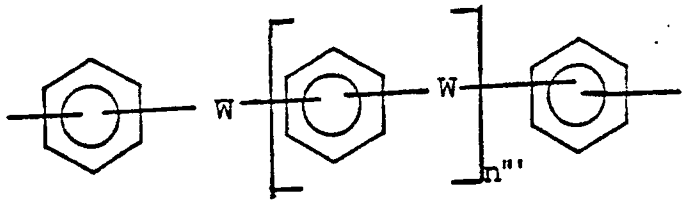

(II)

bedeuten, wobei

W das Bindeglied bildende Gruppe, jeweils eine der folgenden Gruppen sein kann: eine einfache C-C-Bindung; eine Methylengruppe; eine Polymethylengruppe mit 2 bis l2 C-Atomen; eine Difluormethylengruppe; eine Polydifluormethylengruppe mit 2 bis l2 C-Atomen, eine Hexafluorisopropylidengruppe; eine Isopropylidengruppe; eine Oxy- oder Thiogruppe; eine Sulfinylgruppe; eine Sulfonylgruppe; eine Sulfonyldioxygruppe; eine Sulfonamidogruppe; eine Carbonylgruppe oder eine der folgenden Gruppen:

$-(O-SiA_2-O)_{n'}-$ ; $-SiA_2-$

$-SiA_2-O-SiA_2-$ ; 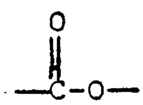

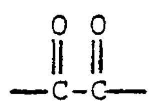 ; 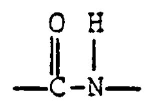

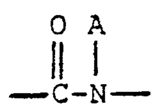 ; 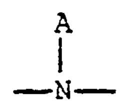

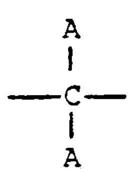 ; 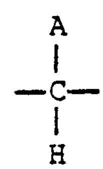

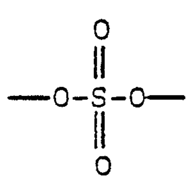 ; 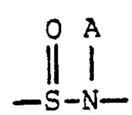

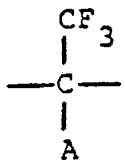 ; 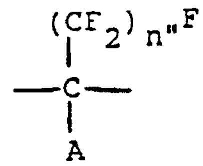

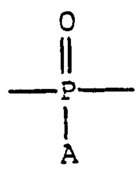 ; 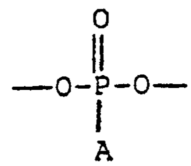

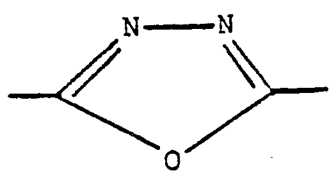 ;

$-D-(CH_2)_{n''}-D-$;

$-(CH_2)_{n''}-D-(CH_2)_{n''}-$ ;

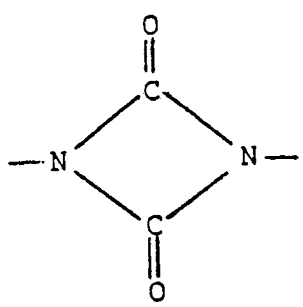

eine Cyclohexylengruppe; eine Cyclohexenylengruppe; eine Naphthylengruppe, sowie Mischungen daraus.

A kann jeweils eine substituierte oder unsubstituierte Alkylgruppe mit l bis 8 C-Atomen; eine substituierte oder unsubstituierte Phenylgrupe oder eine substituierte oder unsubstituierte Naphthylgruppe bedeuten.

D kann jeweils eine der folgenden Gruppen bedeuten: eine Oxygruppe; eine Thiogruppe; eine Carbonylgruppe; eine Oxycarbonylgruppe; eine Sulfonamidogruppe; eine Sulfinylgruppe; eine Sulfonylgruppe; eine Sulfonyldioxygruppe; eine Benzoldicarbonylgruppe; oder eine der folgenden Gruppen:

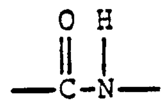 ; 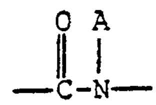 und

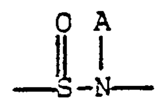 ; 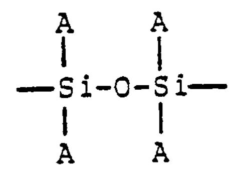

n′ bedeutet eine ganze Zahl von I bis 25 und

n″ eine ganze Zahl von I bis I2.

"Aromatisch" und "cycloaliphatisch" stehen im vorliegenden Fall auch für aromatische und heterocyclische Verbindungen, bei denen ein oder mehrere der C-Atome durch -O-, -S- oder -N-Atome ersetzt sind.

Die Bezeichnung "Polyarylen" definiert eine zweiwertige Gruppe der allgemeinen Formel II

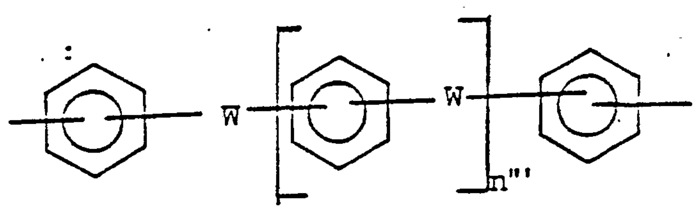

(II)

in der "W" jeweils eine der vorstehend beschriebenen Bindegliedgruppen bezeichnet.

n'" bezeichnet eine der Zahlen 0, I, 2 oder 3, wobei zu beachten ist, daß W keine C-C-Bindung ist, wenn n'" = 0 gilt.

Die Wasserstoffatome der zweiwertigen Gruppen des Typs Y können substituiert sein durch Chlor-, Brom-, Fluor-und Alkylgruppen mit I bis 6 C-Atomen, Perfluoralkylgruppen mit I bis 6 C-Atomen, substituierte oder unsubstituierte Arylgruppen mit 6 bis I2 C-Atomen, Alkyl- oder Arylcarbonsäureester mit 2 bis 9 C-Atomen, Alkoxygruppen mit I bis 6 C-Atomen, Aryloxygruppen mit 6 bis I0 C-Atomen, Acylaminogruppen mit I bis 6 C-Atomen, substituierte oder unsubstituierte Alkylarylgruppen mit 7 bis I2 C-Atomen und durch substituierte oder unsubstituierte Arylalkylgruppen mit 7 bis I2 C-Atomen.

Auch die Wasserstoffatome der zweiwertigen Gruppen des Typs Z können ersetzt sein. Als solche sind beispielsweise Hydroxyl-, Chlor-, Brom-, Fluor- und Alkylgruppen mit I bis 6 C-Atomen, Perfluoralkylgruppen mit I bis 6 C-Atomen, substituierte oder unsubstituierte Arylgruppen mi s I2 C-Atomen, Alkyl- oder Arylcarbonsäureester mit 2 bis 9 C-Atomen, Alkoxygruppen mit I bis 6 C-Atomen, Aryloxygruppen mit 6 bis I0 C-Atomen, Acylaminogruppen mit I bis 6 C-Atomen, substituierte oder unsubstituierte Alkylarylgruppen mit 7 bis I2 C-Atomen und substituierte oder unsubstituierte Arylalkylgruppen mit 7 bis I2 C-Atomen geeignet.

Die Gruppen des Typs Z sind vorzugsweise zu mindestens 70 Mol-% den aromatischen zweiwertigen Gruppen, insbesondere den Gruppen der Formel III

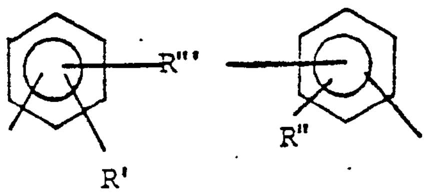

(III)

zuzuordnen, in der R′ und R″ unabhängig voneinander jeweils ein Wasserstoffatom, eine Hydroxylgruppe, eine niedere Alkylgruppe mit mit l bis 6 C-Atomen, eine niedere Alkoxygruppe mit l bis 6 C-Atomen, eine Aryloxygruppe mit 6 bis l0 C-Atomen, eine Chlor-, Fluor- oder Nitrogruppe oder einen aromatischen oder aliphatischen Carbonsäureester mit bis zu l0 C-Atomen bedeuten können, wobei zu beachten ist, daß R′ und R″ nicht gleichzeitig Hydroxylgruppen sein dürfen, wenn R'" eine Hexafluorisopropylidengruppe darstellt; und in der R'" jeweils eine C-C-Bindung, eine Methylengruppe, eine Polymethylengruppe mit 2 bis l6 C-Atomen, eine Isopropylidengruppe, eine Difluormethylengruppe, eine Polydifluormethylengruppe mit 2 bis l2 C-Atomen, eine Sulfonylgruppe, eine Sulfinylgruppe, ein Schwefelatom, ein Sauerstoffatom, eine Carbonyl- oder Oxycarbonylgruppe, eine Hexafluorisopropylidengruppe, eine Benzolcarbonylgruppe oder eine Benzoldioxycarbonylgruppe bedeutet.

Besonders bevorzugt entspricht Z der Formel IV

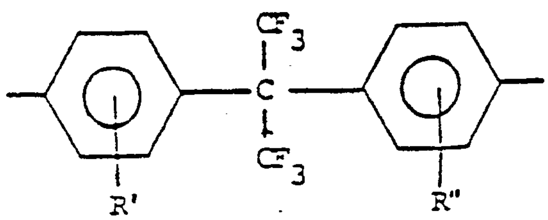

(IV).

Vorzugsweise bestehen Y und Z jeweils zu mindestens 70 Mol-% aus aromatischen zweiwertigen Gruppen oder Mischungen derselben.

Insbesondere stellt Y und/oder Z eine Phenylen-, eine Hexafluor-2,2-bis-(phenyl)propangruppe oder ein Gemisch aus diesen Gruppen dar. Besondersbevorzugt ist Y und/oder Z ein Gemisch aus m-Phenylengruppen, p-Phenylengruppen und Hexafluor-2,2-bis-(p-phenyl)propangruppen, wobei der m-Phenylengruppenanteil bei 20 bis l00 Mol-%, bevorzugt bei 30 bis 70 Mol-%, und insbesondere bei 40 bis 60 Mol-% liegt. Folgende Gemische werden besonders bevorzugt als zweiwertige Gruppe des Typs Y eingesetzt:

1. ein äquimolares Gemisch aus m-Phenylen und p-Phenylen;
2. ein äquimolares Gemisch aus m-Phenylen und Hexafluor2,2-bis(p-phenyl)propan;
3. ein Gemisch aus 50 Mol-% m-Phenylen, 25 Mol-% p-Phenylen und 25 Mol-% Hexafluor-2,2-bis(p-phenyl)propan;
4. ein äquimolares Gemisch aus m-Phenylen, p-Phenylen und Hexafluor-2,2-bis(p-phenyl)propan.

Die Mol-%-angaben beziehen sich jeweils auf den gesamten Molanteil der Gruppen des Typs Y in dem Polymeren.

Da die Polykondensationsreaktion der erfindungsgemäßen Polyamide nach statistischen Gesichtspunkten erfolgt, stellt die allgemeine Formel (I) selbstverständlich auch nur ein Schema des durchschnittlichen Molekülaufbaus der erfindungsgemäßen Polyamide dar, so daß die zweiwertige Gruppe des Typs Z weder eine Methylen- noch eine Difluormethylengruppe sein kann.

Die Herstellung der erfindungsgemäßen Polyamide erfolgt durch Kondensation etwa äquimolarer Mengen an Hexafluor-2,2-bis-(3-amino-4-hydroxyphenyl)propan und einem Chlorid einer zweibasischen Säure, vorzugsweise einem Gemisch entsprechender Säurechloride. Gegebenenfalls können bis zu 80, bevorzugt bis zu 50, und insbesondere bis zu 30 Mol-% des Hexafluor-2,2-bis-(3-amino-4-hydroxyphenyl)-propanmonomeren durch ein weiteres Diaminocomonomeres ersetzt sein, das gegebenenfalls weniger Hydroxylgruppen enthält. Auf diese Weise kann die Lichtempfindlichkeit der positiv arbeitenden lichtempfindlichen Gemische reguliert werden. Für diesen Zweck geeignete Comonomere sind beispielsweise m-Phenylendiamin; p-Phenylendiamin; 4,4′-Diaminodiphenylether; 3,3′-Diaminodiphenylether; 3,4′-Diaminodiphenylether; l,3-Bis-(aminophenoxy)benzol (m-APB); l,4-Bis-( henoxy)benzol (p-APB); Benzidin; 3,3′-Dimethoxybenzidin; 3,3′-Dimethylbenzidin; 3,3′-Dihydroxybenzidin; 3,3′-Diaminodiphenylmethan; 4,4′-Diaminodi-

phenylmethan; 4,4'-Diaminodiphenylpropan; 3,3'-Diaminodiphenylsulfon; 4,4'-Diaminodiphenylsulfon; 4,4'-Diaminodiphenylsulfid; 3,3'-Dihydroxy-4,4'diaminodiphenylsulfon; Bis-(3-hydroxy-4-aminophenyl)-methan; 3,3'-Dihydroxy-4,4'-diaminobenzophenon; α,α-Bis-(aminophenyl)p-diisopropylbenzol; l,3-Bis[4(4-aminophenoxy)-α,α-bistrifluormethyl]benzol; 2,2-Bis[4-(4-aminophenoxy)-phenyl]hexafluorpropan; Hexafluor-2,2-bis-(3-amino-4-methylhexafluor-2,2-bis-(4-aminophenyl)propan; Hexafluor-2,2-bis-(3-aminophenyl)propan; l,2-Bis(3-aminopropoxy)ethan; m-Xylylendiamin; p-Xylylendiamin; Bis-(4-aminocyclohexyl)methan; Hexamethylendiamin; Octamethylendiamin; Decamethylendiamin; Dodecamethylendiamin; l,4-Cyclohexandiamin; Bis-(3-aminopropyl)sulfid; N-Methyl-bis-(3-aminopropyl)amin; 4,4'-Bis-(p-aminophenoxy)diphenylsulfid; 4,4'-Bis-(3''-aminophenoxy)diphenylsulfid; 4,4'-(3''-Aminophenoxy-(4'-aminophenoxy)-diphenylsulfid; 4,4'-Bis-(p-aminophenoxy)-diphenylsulfon; 4,4'Bis(3''-amino)phenylsulfon; 2,2-Bis-[4'-p-(aminophenoxy)phenyl]propan; 2,2-Bis-[3'-(p-aminophenoxy)phenyl]propan; l,l-Bis-[4'-(p-aminophenoxy)phenyl]ethylbenzol und Gemische aus zwei oder mehreren der genannten Verbindungen.

Es ist auch möglich, das Polyamid nach seiner Polykondensation zu modifizieren, zum Beispiel durch Acylierung eines Teils seiner Hydroxylgruppen, wobei als Acylierungsmittel ein aliphatisches oder aromatisches Carbonsäurederivat mit bis zu l0 C-Atomen verwendet wird, wie zum Beispiel Essigsäureanhydrid, Propionsäureanhydrid, Benzoesäurechlorid oder ein Diketen.

Die Herstellung der Diaminoverbindungen und der Chloride zweibasischer Säuren, die als Monomere bei der Herstellung der erfindungsgemäßen Polyamide eingesetzt werden können, erfolgt nach bekannten Verfahren, die beispielsweise in "Synthesis of Polymer Intermediates Containing the Hexafluorisopropylidene Group", von K.S.Lau, A.L. Landis, W.J. Kelleghan und C.D. Beard, in J. Polym. Sci., Bd. 20, S. 238l-239l, (l982) beschrieben werden.

Die Herstellung der erfindungsgemäßen Polyamide erfolgt nach bekannten Polymerisationsverfahren, die beispielsweise in "Preparation of Fully Aromatic Polybenzoxazoles" von T. Kubota und R. Nakanishiu, in Polymer Letters, Bd. 2, S. 655 - 659 (l964) beschrieben sind, worin ein typisches Verfahren der Kondensation eines Diamines mit einem Säurechlorid vorgestellt wird.

Die Herstellung der erfindungsgemäßen Polyamide geht aus von Hexafluor-2,2-bis-(3-amino-4-hydroxyphenyl)propan oder einem analog reagierenden Abkömmling, z.B. Hexafluor-2,2-bis-(3-amino-4-methoxyphenyl)propan, in der die Hydroxylgruppe durch eine Alkoxy- oder Aryloxygruppe mit bis zu l0 C-Atomen ersetzt wurde, z.B. durch eine Ethoxy-, Propoxy-, Butoxy- oder eine Phenoxygruppe. Der Anteil dieses Diamins an den gesamten Diaminbestandteilen des Polymeren beträgt etwa 20 bis l00 Mol-%, insbesondere 70 bis l00 Mol-% und bevorzugt etwa 50 Mol-%.

Zu den für die Herstellung der erfindungsgemäßen Polyamide typischerweise verwendeten Säurechloride zählen die Säurechloride der Isophthalsäure; der Terephthalsäure; der 4,4'-Hexafluorisopropylidendibenzoesäure; der l,4-Cyclohexandicarbonsäure; der Pentandicarbonsäure; der Hexandicarbonsäure; der Phthalsäure; der 2,4-Furandicarbonsäure, der l,4-Phenylen-diethancarbonsäure; der 4,4'-Biphenyldicarbonsäure; von l,l-Bis-(4-carboxyphenyl)-l-phenyl-2,2,2-trifluorethan; von 4,4'-Dicarboxydiphenylether; von Bis-(4-carboxyphenyl)-methylphosphanoxid; von 4,4'-Dicarboxytetraphenylsilan; von Bis-(4-carboxy-phenyl)-sulfon; der 5-tert.Butylisophthalsäure; der 5-Brom-isophthalsäure, der 5-Fluor-isophthalsäure; der 5-Chlor-isophthalsäure; von 2,2-Bis(p-carboxyphenyl)propan; der 4,4'-(p-Phenylendioxy)dibenzoesäure ; der 2,6-Naphthalindicarbonsäure und Gemische dieser Verbindungen.

Die erfindungsgemäßen Polyamide finden in positiv arbeitenden lichtempfindlichen Gemischen Verwendung. Die Gemische enthalten im wesentlichen eines der erfindungsgemäßen Polyamide sowie eine lichtempfindliche Verbindung. Diese Komponenten werden ggf. in einem geeigneten Lösemittel gelöst und auf das jeweils gewünschte Trägermaterial aufgebracht. Die Herstellung der Photoresists ist bekannt und wird nach einem der gebräuchlichen Verfahren durchgeführt.

Dem Fachmann ist in diesem Zusammenhang die Verwendung von o-Chinondiaziden bekannt, wie in "Light Sensitive Systems" von J. Kosar, John Wiley & Sons, New York, l965, Kapitel 7.4, beschrieben ist. Diese lichtempfindlichen Verbindungen gehören zur Gruppe der substituierten lichtempfindlichen Naphthochinondiazide, wie sie üblicherweise in positiv arbeitenden lichtempfindlichen Gemischen verwendet werden. Solche Verbindungen sind zum Beispiel aus US-A 2 797 213, US-A 3 106 465, US-A 3 148 983, US-A 3 130 047, US-A 3 201 329, US-A 3 785 825 und US-A 3 802 885 bekannt. Geeignete lichtempfindliche Verbindungen sind zum Beispiel auch mit phenolishchen Verbindungen, wie Hydroxybenzophenonen, kondensiertes 1,2-Naphthochinondiazid-5-sulfonylchlorid und 1,2-Naphthochinondiazid-4-sulfonylchlorid.

Der Lösung aus Polyamid, lichtempfindicher Verbindung und Lösemittel können vor dem Aufbringen auf einen Schichtträger noch Zusätze, wie. z. B. Farbmittel, Farbstoffe, Verlaufmittel, Weichmacher, Haftvermittler, Entwicklungsbeschleuniger, weitere Lösemittel und Tenside, z. B. nicht-ionische Tenside, zugegeben werden.

Farbstoffe, die als Zusätze für die erfindunggsgemäßen lichtemfindlichen Gemische verwendet werden

können, sind zum Beispiel Methylviolett 2B (C.I. 42 535), Kristallviolett (C.I. 42 555), Malachitgrün (C.I. 42 00), Victoriablau B (C.I. 44 045) und Neutralrot (C.I. 50 040). Diese Farbstoffe werden in einer Menge von 1 bis 10 Gewichtsprozent, bezcgen auf das Gesamtgewicht von Polyamid und lichtempfindlicher Verbindung, zugesetzt. Die Farbstoffzusätze verringern die Rückstreuung von Licht vom Träger und tragen so zu einer verbesserten Auflösung bei.

Verlaufmittel können in einer Menge bis zu 5 Gewichtsprozent, bezogen auf das Gesamtgewicht von Polyamid und lichtempfindlicher Verbindung, eingesetzt werden.

Geeignete Haftvermittler sind zum Beispiel $\beta$-(3,4-Epoxycyclohexyl)-ethyltrimethoxysilan, p-Methyldisilanmethylmethacrylat, Vinyltrichlorsilan und $\gamma$-Aminopropyltriethoxysilan in einem Anteil bis zu 4 Gewichtsprozent, bezogen auf das Gesamtgewicht von Polyamid und lichtempfindlicher Verbindung.

Als Entwicklungsbeschleuniger können beispielsweise Pikrinsäure, Nicotinsäure oder Nitrozimtsäure in einem Anteil bis zu 20 Gewichtsprozent, bezogen auf das Gesamtgewicht von Polyamid und lichtempfindlicher Verbindung, zugegeben werden. Diese Beschleuniger führen dazu, daß die Löslichkeit der Photoresistschicht sowohl in den belichteten als auch in den unbelichteten Bereichen zunimmt. Sie werden bei solchen Anwendungen eingesetzt, bei denen es in erster Linie auf die Entwicklungsgeschwindigkeit ankommt, auch wenn dabei eventuell ein gewisser Grad an Kontrast geopfert wird; denn während die belichteten Bereiche der Photoresistschicht durch den Zusatz von Beschleunigern vom Entwickler schneller gelöst werden, bewirken die Entwicklungsbeschleuniger gleichzeitig auch einen größeren Verlust an Photoresistschicht aus den unbelichteten Bereichen.

Als Lösemittel sind bei der Herstellung der erfindungsgemäßen Photoresistgemische alle für diesen Zweck typischen, handelsüblichen Lösemittel geeignet. Der Anteil des Lösemittels an der gesamten Photoresistlösung kann bis zu 95 Gewichtsprozent betragen. Die Löslichkeit der bekannten Polyamide in N-Methylpyrrolidon und Dimethylacetamid ist begrenzt, während die erfindungsgemäßen Polyamide in diesen Lösemitteln und in weiteren handelsüblichen Lösemitteln sehr gut löslich sind. Zu den geeigneten Lösemitteln gehören neben N-Methylpyrrolidon und Dimethylacetamid beispielsweise Propylenglykolmethylether, Methylethylketon, Cyclohexanon, Butyrolacton und Gemische daraus. Bevorzugt werden N-Methylpyrrolidon und Propylenglykolmethylether verwendet.

Die fertige Photoresistlösung kann nach einem der in der Photoresisttechnik üblichen Verfahren, wie Tauchen, Sprühen und Aufschleudern, auf einen Träger aufgebracht werden. Beim Aufschleudern kann zum Beispiel der Prozentanteil an Feststoffen in der Resistlösung so eingestellt werden, daß sich in Abhängigkeit von der im Einzelfall verwendeten Aufschleudervorrichtung und der für den Aufschleudervorgang angesetzten Zeitspanne eine Beschichtung in der gewünschten Dicke ergibt. Beispiele für geeignete Trägermaterialien sind: Silicium, Aluminium oder polymere Harze, Siliciumdioxid, dotiertes Siliciumdioxid, Siliciumnitrid, Tantal, Kupfer, polykristallines Silicium (polysilicon), Keramik und Aluminium/Kupfer-Legierungen.

Die nach dem beschriebenen Verfahren hergestellten Photoresistlösungen eignen sich insbesondere zum Auftragen auf Silicium-Wafer, die eine Schicht aus thermisch gezüchtetem Siliciumdioxid tragen, wie sie bei der Herstellung von Mikroprozessoren und anderen in der Mikroelektronik verwendeten Halbleiterbauelementen verwendet werden. Ebenso kann auch ein Wafer aus Aluminium mit einer Aluminiumoxidschicht eingesetzt werden. Der Träger kann auch aus verschiedenen polymeren Harzen, insbesondere aus transparenten Polymern, wie zum Beispiel Polyestern, bestehen.

Als Entwicklerlösungen für die erfindungsgemäßen lichtempfindlichen Gemische sind wäßrige Lösungen anorganischer alkalischer Verbindungen, wie Natriumsilicat, Kaliumsilicat, Natriumhydroxid, Kaliumhydroxid, Lithiumhydroxid, Natriumphosphat, Natriummonohydrogenphosphat, Ammoniumphosphat, Ammoniummonohydrogenphosphat, Natriummetasilicat, Natriumbicarbonat, Ammoniak, usw. geeignet, wobei die Konzentration dieser Verbindungen bei 0,l bis l0 Gew.-%, vorzugsweise bei 0,5 bis 5 Gew.-%, liegen kann. Beispielhafte geeignete Entwicklerlösungen sind unter anderem in US-A 3 l10 596, US-A 3 l73 788 und US-A 3 586 504 genau beschrieben.

In den alkalischen Entwicklerlösungen können im Einzelfall außerdem bestimmte organische Lösemittel, wie Alkohole(z. B. Methanol, Ethanol, Benzylalkohol, usw.), und Netzmittel (z. B. Natriumalkylnaphthalinsulfonat, Natriumlaurylsulfat, usw.) enthalten sein.

Nach dem Auftragen der Photoresistlösung auf den Schichtträger wird der Träger einer Vortrocknung bei etwa 80 bis l05 °C, vorzugsweise bei Temperaturen um 90 °C, unterworfen. Diese Wärmebehandlung erfolgt bis das Lösemittel oder Lösemittelgemisch im wesentlichen vollständig verdampft ist und nur eine dünne Schicht aus Photoresistgemisch, deren Dicke etwa l $\mu$m beträgt, auf dem Schichtträger zurückbleibt.

Der beschichtete Träger wird anschließend in bekannter Weise mittels aktinischer Strahlung durch geeignete Masken, Negative, Schablonen, usw. bildmäßig belichtet.

Als nächstes werden die mit dem Photoresistgemisch beschichteten und belichteten Schichtträger in eine wäßrig-alkalische Entwicklerlösung getaucht. Die Lösung wird vorzugsweise stark bewegt, was zum

Beispiel durch Durchblasen von Stickstoff erfolgen kann.

Die Träger bleiben im Entwicklerbad, bis die Photoresistschicht an den belichteten Stellen ganz oder wenigstens fast ganz abgelöst ist.

Nach dem Herausnehmen der beschichteten Wafer aus der Entwicklerlösung kann eine Wärmenachbehandlung bzw. Einbrennbehandlung durchgeführt werden, um die Haftung und die chemische Beständigkeit der Schicht gegen Ätzlösungen und andere Substanzen zu erhöhen.

Die Haftung der erfindungsgemäßen lichtempfindlichen Schicht auf Trägermaterialien wie z. B. Siliciumwafer, Aluminiumplatten, Glas, Polyesterfolien, usw., ist ausgezeichnet. Für die Verarbeitung der Gemische braucht daher keine haftvermittelnde Schicht auf den Träger aufgetragen zu werden. Die Wärmebehandlung nach dem Entwickeln kann in einem Ofen bei Temperaturen unterhalb des Erweichungspunktes der Schicht erfolgen. Die Temperaturen liegen zwischen 80 und 375 °C, bevorzugt zwischen 225 und 350 °C. Die Dauer dieser Wärmebehandlung schwankt zwischen 30 min und 2 h. Die Glasübergangstemperatur (Tg) des Polyamids beträgt vor der Wärmebehandlung üblicherweise 250 bis 300 °C, nach der Wärmebehandlung und Umwandlung des Polyamids in ein Polyoxazol liegt sie bei 300 bis 350 °C, insbesondere bei 305 bis 325 °C.

Im Anschluß an die Härtung kann das entwickelte Material noch mit einer gepufferten Lösung auf der Basis von Flußsäure oder mit einer alkalischen Ätzlösung behandelt werden. Die erfindungsgemäßen Photoresistgemische sind gegen alkalische und saure Ätzlösungen gleichermaßen resistent und stellen einen wirksamen Schutz für die unbelichteten, d. h., resistbedeckten Flächen des Trägers, dar. Das entwickelte und gehärtete Photoresistmaterial weist Reliefbilder von ausgezeichneter Auflösung und Schärfe auf und besitzt eine ausgezeichnete Wärmebeständigkeit.

Obwohl die Erfindung vorstehend nur im Hinblick auf ein Feuchtätzverfahren beschrieben wurde, sind die erfindungsgemäß hergestellten Reliefbilder auch für Trockenätzverfahren geeignet. Die erhaltenen Photoresiststrukturen sind hervorragend geeignet als Isolierschichten bei der Halbleiterherstellung oder als Masken für Dampfbeschichtungsverfahren, Ionenimplantationsverfahren, usw. Außerdem können die erfindungsgemäßen Photoresists zur Herstellung von Druckplatten, Prüffolien für den Flachdruck, Bildübertragungsfolien für den Flachdruck und zu ähnlichen Zwecken verwendet werden. Die Herstellung von Druckplatten von positiv arbeitenden Photoresists ist bekannt und zum Beispiel in US-A 3 493 37l beschrieben.

Die erfindungsgemäßen Photoresists können auch als Schutzüberzüge auf zahlreichen anderen, den Fachleuten wohlbekannten Gebieten eingesetzt werden. Durch ihre gute Löslichkeit sind zudem die erfindungsgemäßen Polyamide für hochtemperaturbeständige Schutzüberzüge ebenso geeignet wie für Photoresistgemische. Ein typisches Beschichtungsgemisch für einen Schutzüberzug enthält beispielsweise 5 bis 30 Gew.-% des erfindungsgemäßen Polyamids in Lösung zum Aufbringen auf ein Trägermaterial. Der Beschichtungslösung können noch weitere Bestandteile, wie Antioxidantien, UV-Stabilisatoren, Haftvermittler, Farbmittel, flammhemmende Mittel, Füllstoffe und weitere Hilfsmittel in einer Gesamtmenge bis zu 20 Gew.-% zugesetzt sein. Die Entfernung des Lösemittels erfolgt bei erhöhter Temperatur, im allgemeinen im Bereich von 90 bis l50 °C, gegebenenfalls kann zur Erleichterung dieses Verfahrensschrittes auch Unterdruck eingesetzt werden. Anschließend wird das mit dem Polyamid beschichtete Material während einer Dauer von etwa einer halben Stunde bis zu sechs Stunden auf eine Temperatur von 200 bis 350 °C erhitzt, wodurch das Polyamid in ein hochtemperaturbeständiges Polyoxazol umgewandelt wird.

In den folgenden Beispielen werden die Verfahren zur Herstellung und Anwendung von erfindungsgemäßen Gemischen eingehend erläutert. Diese Beispiele sollen jedoch die Erfindung in keiner Weise in ihrem Umfang beschränken, und sie sollen nicht dahingehend ausgelegt werden, daß sie Bedingungen, Parameter oder andere Werte angeben, die zur praktischen Ausführung der Erfindung ausschließlich anzuwenden sind. Der Ausdruck "Schichtabtrag im Dunkeln" wurde in den Beispielen zu "Abtrag" verkürzt.

<u>Beispiel l</u>

Durch eine Polykondensation in Lösung wurde ein Polyamid der folgenden allgemeinen Formel hergestellt:

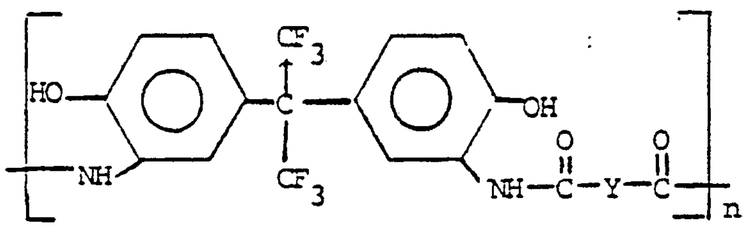

In der Formel bedeutet Y ein äquimolares Gemisch (50:50 Molteile) aus Isophthaloyl- und Terephthaloylgruppen, und n steht für eine Zahl um 200.

Zu einer Lösung aus 0,0l mol (= 3,66 mg) Hexafluor-2,2-bis(3-amino-4-hydroxyphenyl)propan in l6,5 ml Dimethylacetamid und 3 ml Pyridin wurde bei einer Temperatur von -l0 bis -l5 -C innerhalb von 30 min unter kräftigem Rühren ein äquimolares Gemisch aus 5,5 mmol (=l,ll65 mg) Isophthaloylchlorid und 5,5 mmol (=l,ll65 mg) Terephthaloylchlorid zugetropft. Das Gemisch wurde weitere 24 Stunden bei Raumtemperatur gerührt, und anschließend wurde die erhaltene Lösung zur Ausfällung des Polymeren in Eiswasser gegossen. Das ausgefallene Polyamid wurde abgefiltert, mit Wasser gewaschen und bei 90 °C über Nacht im Vakuum getrocknet.

Das Polymer wurde in nahezu quantitativer Ausbeute erhalten und besaß eine logarithmische Viscositätszahl von 0,40 $dlg^{-1}$, gemessen in 0,5 % Dimethylacetamid bei 25 °C.

Beispiel 2

Zur Herstellung einer Photoresistlösung wurden l0 Gt (Gewichtsteile) der in Beispiel l beschriebenen polymeren Vorstufe für ein Polybenzoxazol, 5 Gt einer lichtempfindlichen Verbindung (ein gemischter Trisester von Trihydroxybenzophenon) und 0,08 Gt eines roten Farbstoffes in l2 Gt Methylethylketon und 8,0 Gt Propylenglykolmethylether gelöst. Die Lösung wurde filtriert und anschließend durch Walzenantrag auf eine anodisch oxidierte Aluminiumplatte aufgetragen. Nach einer Trocknungszeit von 3 Minuten bei 90 °C wurde eine 2 bis 3 µm starke Resistschicht auf dem Trägermaterial erhalten.

Eine Photomaske mit einem Strichmuster wurde so auf die Resistschicht gelegt, daß die Schicht und die Photomaske in engem Kontakt miteinander standen. Die Belichtung mit UV-Licht erfolgte mittels einer Quecksilberdampflampe einer Leistung von 200 W für 60 Sekunden. Die Intensität des UV-Lichts bei einer Wellenlänge von 365 nm auf der Schichtoberfläche betrug 5 $mW/cm^2$. Im Anschluß an die Belichtung wurde mit einem Gemisch aus einem alkalischen Entwickler (AZ Developer, Hoechst Celanese Corp.) und Wasser (1:5) entwickelt. Die entwickelte Platte wurde mit Wasser gewaschen. Das erhaltene Bild zeigte ein feines, gleichmäßiges Reliefmuster, in dem Strichbreiten bis zu 3 µm wiedergegeben waren. Anschließend wurde die Platte einer Wärmebehandlung bei 250 °C für 1 h unterworfen.

Sogar nach einer Wärmebehandlung von 6 h bei 250 °C war das Bild noch randscharf und von unverändert guter Auflösung. Es konnten auch keine Haarrisse als Folge der Entwicklung und Wärmebehandlung festgestellt werden. Nach der Wärmebehandlung wurde lediglich ein geringer Schichtverlust gemessen.

Beispiel 3

Zur Herstellung einer Photoresistlösung wurden l0 Gt einer gemäß Beispiel l hergestellten polymeren Vorstufe für ein Polybenzoxazol, eines Polykondensationsproduktes aus Hexafluor-2,2-bis(3-amino-4-hydroxyphenyl)propan und 5 Gt einer lichtempfindlichen Verbindung (ein gemischter Trisester von Trihydroxybenzophenon) und 0,08 Gt eines roten Farbstoffes (Disperse Red l79) in l2 Gt Methylethylketon und 8,0 Gt Propylenglykolmethylether gelöst. Die Lösung wurde filtriert und anschließend durch Walzenantrag auf eine anodisch oxidierte Aluminiumplatte aufgetragen. Nach einer Trocknungszeit von 3 Minuten bei 90 °C wurde eine 2 bis 3 µm starke Resistschicht auf dem Trägermaterial erhalten.

Zur Belichtung wurde eine Photomaske mit einem Strichmuster so auf die Resistschicht gelegt, daß die Schicht und die Photomaske in engem Kontakt miteinander waren. Die Belichtung mit UV-Licht erfolgte mittels einer Quecksilberdampflampe einer Leistung von 200 W für 60 s. Die Intensität des UV-Lichts einer Wellenlänge von 365 nm auf der Schichtoberfläche betrug 5 $mW/cm^2$.

Im Anschluß an die Belichtung wurde mit einem Gemisch aus einem alkalischen Entwickler (AZ Developer, Hoechst Celanese Corp.) und Wasser (1:5) entwickelt. Die entwickelte Platte wurde mit Wasser

gewaschen. Das erhaltene Bild zeigte ein feines, gleichmäßiges Reliefmuster, in dem Strichbreiten bis zu 3 µm wiedergegeben waren. Anschließend wurde die Platte einer Wärmebehandlung bei 250 °C für 1 h unterworfen.

Sogar nach einer Wärmebehandlung von 6 h bei 250 °C war das Bild noch randscharf und von unverändert guter Auflösung. Es konnten auch keine Haarrisse als Folge der Entwicklung und Wärmebehandlung festgestellt werden.

Beispiel 4

Anhand dieses Beispiels wird die Acetylierung der Hydroxylgruppen des erfindungsgemäßen Polyamids (Kondensationsprodukt aus Hexafluor-2,2-bis(3-aminohydroxyphenyl)propan und einem äquimolaren Gemisch aus Isophthaloyl- und Terephthaloylchlorid) dargestellt.

4,96 mg (=0,01 mol) des Polyamidcopolymeren wurden in einem mit Rührwerk, Rückflußkühler und Thermometer ausgerüsteten 100 ml-Dreihalskolben in 25 ml Dimethylacetamid gelöst und unter Rühren auf 100 °C erhitzt und 0,2 mg Essigsäureanhydrid zugegeben. Das Reaktionsgemisch wurde 7 Stunden bei 100 °C gehalten und anschließend in Eiswasser gegossen. Es wurde ein weißes, festes, fasriges Polymeres erhalten, das mit Wasser gewaschen und über Nacht in einem Vakuumschrank bei 100 °C getrocknet wurde. Etwa 20 % der Hydroxylgruppen des Polymeren waren verestert.

Die nachstehende Tabelle I verdeutlicht die gute Löslichkeit der erfindungsgemäßen, eingesetzten Polyamide. Das Polymere A, das nach Beispiel I hergestellt wurde, ist ein Kondensationsprodukt aus Hexafluor-2,2-bis-(3-amino-4-hydroxyphenyl)propan und einem äquimolaren Gemisch aus Isophthaloylchlorid und Terephthaloylchlorid. Das Polymere B, das nach dem Verfahren gemäß Beispiel 1 der US-A 4 395 482 hergestellt wurde, ist ein Kondensationsprodukt aus 3,3'-Dihydroxybenzidin und Isophthaloylchlorid.

Tabelle 1

| Lösemittel | Löslichkeit (Gew.-%) Polymeres A | Polymeres B |
|---|---|---|
| N-Methylpyrrolidon | 30 | <20* |
| Dimethylacetamid | 30 | <20* |
| Propylenglykolmethylether | 30 | unlöslich |
| Methylethylketon | 20 | unlöslich |
| Cyclohexanon | 20 | unlöslich |
| Butyrolacton | 20 | unlöslich |

*unvollständig gelöst, Gelbildung

Die folgenden Vergleichsbeispiele wurden durchgeführt, um die Überlegenheit der erfindungsgemäßen positiv arbeitenden Photoresistgemische, insbesondere von Photoresistgemischen, in denen die erfindungsgemäßen Polyamide enthalten sind, gegenüber bekannten Gemischen zu verdeutlichen.

Dazu wurden zunächst Photoresistgemische hergestellt, in denen erfindungsgemäße Polyamide (polymere Vorstufen für Polyoxazole) eingesetzt wurden, die im wesentlichen nach dem in Beispiel I der vorliegenden Anmeldung beschriebenen Verfahren erhalten worden waren. Außerdem wurden Photoresistgemische hergestellt, die ein Poly(benzidin-isophthalamid) gemäß Beispiel I der US-A 4 339 521 enthielten.

Anschließend wurde anhand des nachstehend beschriebenen Verfahrens die Lichtempfindlichkeit jedes Gemisches bestimmt. Die Dauer der jeweiligen Wärmebehandlung, die Aufschleudergeschwindigkeit und andere Parameter der einzelnen Versuche sind ebenfalls nachstehend angegeben:
Die Photoresistgemische wurden mit einer konstanten Geschwindigkeit (im Bereich von 500 bis 1.500 U/min) auf Siliciumwafer aufgeschleudert. Die Wafer wurden bei 90 °C 30 bis 45 min getrocknet, um das Lösemittel zu entfernen. Die ursprüngliche Dicke der aufgebrachten, trockenen Photoresistschichten wurde

mit einem Rudolph-Dickenmeßgerät ermittelt. Die Lichtempfindlichkeit wurde gemessen, indem eine Kontrastkurve erstellt wurde, wie in "C. G. Willson, Introduction to Microlithography, Kap. 3, S. l05, American Chemical Society, Washington, D.C., l983" beschrieben. Dabei wird der Schichtdickenverlust nach einer Entwicklungszeit von einer Minute gegen den Logarithmus (ln) der UV-Belichtungsdosis aufgetragen. Die Schichtdickenmessung erfolgte mittels Laserinterferometrie nach dem beschriebenen Verfahren. Der Photoresist wurde mit einer mit entionisiertem Wasser verdünnten Lösung eines wäßrig-alkalischen Entwicklers bei einer Temperatur von 25,0 °C ± 0,5 °C entwickelt. Durch Extrapolieren der Kurve auf den gesamten Schichtdickenverlust wird der jeweilige Lichtempfindlichkeitswert (mJ/cm$^2$) erhalten.

Die folgenden lichtempfindlichen Verbindungen wurden eingesetzt. Sie sind in den Beispielen kurz mit a), b) oder c) bezeichnet.

a) l,2-Naphthochinondiazidsulfonsäuremischester von Trihydroxybenzophenon;

b) 1,2-Naphthochinondiazid-5-sulfonsäuretrisester von Trihydroxyoctanophenon;

c) Bis-1,2-naphthochinondiazid-5-sulfonsäureester von 2,2-Bis-(4-hydroxyphenyl)propan (lichtempfindliche Verbindung aus Beispiel 1 der US-A 4 339 521).

Beispiel 5

Zur Herstellung einer Photoresistlösung wurden l5 Gt des Polyamids aus Beispiel l und l5 Gt der lichtempfindlichen Verbindung b) in 70 Gt eines Lösemittelgemischs aus gleichen Teilen Propylenglykolmethylether und N-Methylpyrrolidon gelöst. Ein Wafer wurde mit dieser Lösung schleuderbeschichtet, getrocknet und mit Hilfe einer 200 W starken Quecksilberdampflampe mit Licht einer Wellenlänge von 365 nm wie bereits beschrieben belichtet. Die Entwicklerkonzentration betrug l Teil AZ Developer: 2 Teile Wasser. Der erhaltene Resist wurde in der beschriebenen Weise ausgewertet. Folgende Ergebnisse wurden erhalten:

Lichtempfindichkeit: 76,4 mJ/cm$^2$

Abtrag: 0,007 µm/min

Die beschriebene Kennkurve des Resists lag im Normalbereich; die Haftung des Resists auf dem Wafer war ausgezeichnet.

Beispiel 6

Aus l6 Gt des Polyamids von Beispiel l, 8 Gt der lichtempfindlichen Verbindung b) und 76 Gt eines äquimolaren Gemischs aus N-Methylpyrrolidon und Propylenglykolmethylether wurde eine Photoresistlösung hergestellt. Es wurde verfahren wie in Beispiel 5, die Entwicklung erfolgte in einem Gemisch aus AZ Developer und Wasser im Verhältnis 1:8.

Folgende Ergebnisse wurden erhalten:

Lichtempfindlichkeit: 74,8 mJ/cm$^2$

Abtrag: 0,0l9 µm/min

Die Kennkurve des Resists lag im Normalbereich; die Haftung des Resists auf dem Wafer war ausgezeichnet.

Beispiel 7

Nach den Angaben von Beispiel 1 wurde ein Polyamid hergestellt, mit der Ausnahme, daß 30 Mol-% Hexafluor-2,2-bis(3-amino-4-hydroxyphenyl)propan durch die gleiche Molmenge Hexafluor-2,2-bis(3-amino-4-methyl)propan ersetzt wurden. Das resultierende Polyamid wurde in der Photoresistrezeptur von Beispiel 5 eingesetzt. Entwickelt wurde mit einem Gemisch aus AZ Developer und Wasser im Verhältnis l:6, ansonsten wurde wie in Beispiel 5 verfahren.

Folgende Ergebnisse wurden erhalten:

Lichtempfindichkeit: 65 mJ/cm$^2$

Abtrag: 0,0l6 µm/min

Die Kennkurve des Resists lag im Normalbereich; die Haftung des Resists auf dem Wafer war ausgezeichnet.

Beispiel 8

Unter Verwendung des Polyamids aus Beispiel 7 wurde nach dem bereits beschriebenen Verfahren ein Photoresistgemisch hergestellt und ausgewertet. Dazu wurden 20 Gt des Polyamids aus Beispiel 7 und I0 Gt der lichtempfindlichen Verbindung b) in 70 Gt eines aus gleichen Molteilen an Propylenglykolmethylether und N-Methylpyrrolidon bestehenden Gemischs gelöst. Als Entwickler wurde ein Gemisch aus I Gt AZ Developer und 2 Gt Wasser verwendet.

Folgende Ergebnisse wurden erhalten:
Lichtempfindlichkeit: 8I mJ/cm$^2$
Abtrag: 0,007 µm/min

Beispiel 9

Unter Verwendung des Polyamids aus Beispiel 4 wurde nach dem in Beispiel 5 beschriebenen Verfahren ein Photoresistgemisch hergestellt und ausgewertet. Dazu wurden I3 Gt des acylierten Polyamids aus Beispiel 4 und I3 Gt der lichtempfindlichen Verbindung b) in 74 Gt eines aus gleichen Teilen an Propylenglykolmethylether und N-Methylpyrrolidon bestehenden Lösemittelgemischs gelöst. Als Entwickler wurde ein Gemisch aus I Gt AZ Developer und 2 Gt Wasser verwendet.

Folgende Ergebnisse wurden erhalten:
Lichtempfindlichkeit: 77,6 mJ/cm$^2$
Abtrag: 0,0II µm/min

Die Kennkurve lag im Normalbereich; die Haftung des Resists auf dem Wafer war ausgezeichnet.

Beispiel I0

Nach dem in Beispiel I beschriebenen Verfahren wurde ein Polyamid hergestellt, wobei aber 30 Mol-% des dort eingesetzten Diaminomonomeren durch Dianisidin als Comonomeres ersetzt wurden und Terephthaloylchlorid als Säurechlorid verwendet wurde.

Die Eigenschaften des Photoresistgemischs wurden nach dem in Beispiel 5 beschriebenen Verfahren bewertet.

Das Photoresistgemisch enthielt I5 Gt des Polyamidcopolymeren, I5 Gt der lichtempfindlichen Verbindung b) und 70 Gt eines Lösemittelgemischs aus gleichen Teilen N-Methylpyrrolidon und Propylenglykolmethylether. Die Entwicklerkonzentration betrug I Gt AZ Developer auf 2 Gt Wasser.
Lichtempfindlichkeit: I99,5 mJ/cm$^2$
Abtrag: 0,0I3 µm/min

Beispiel II

Es wurde ein Polyamid gemäß Beispiel 1 hergestellt mit der Ausnahme, daß 20 Mol-% des Diaminomonomeren des Beispiels 1 durch einen äquimolaren Anteil an Hexafluoro-2,2-bis(3-amino-4-methylphenyl)-propan ersetzt wurden und Terephthaloylchlorid als zweibasisches Säurechlorid verwendet wurde.

15 Gt des resultierenden Polyamids und 15 Gt der lichtempfindlichen Verbindung a) wurden in 70 Gt N-Methylpyrrolidon gelöst. Die mit dieser Lösung beschichteten Wafer wurden gemäß den vorherigen Beispielen hergestellt und getestet. Als Entwicklerlösung wurde eine Mischung aus 1 Gt AZ Developer und 2 Gt Wasser verwendet.

Folgende Ergebnisse wurden erhalten:
Lichtempfindlichkeit: 237,9 mJ/cm$^2$
Abtrag: 0,008 µm/min

Beispiel 12 (Vergleichsbeispiel)

Entsprechend Beispiel 5 wurde eine Lösung hergestellt aus 8,5 Gt Poly-(dihydroxybenzidinisophthalamid), hergestellt nach den Angaben des Beispiels 1 der US-A 4 339 521 und 8,5 Gt der lichtempfindlichen Verbindung b) in 83 Gt N-Methylpyrrolidon.

Bei einer Geschwindigkeit von 500 U/min wurde diese Lösung auf einen Wafer aufgeschleudert und entsprechend den Angaben der vorliegenden Beispiele weiterverarbeitet.

Als Entwickler wurde eine Lösung aus 1 Gt AZ-Developer und 5 Gt Wasser verwendet.

Folgende Ergebnisse wurden erhalten:

Lichtempfindlichkeit: 589 mJ/cm$^2$

Abtrag: 0,015 µm/min

Beispiel 13 (Vergleichsbeispiel)

Beispiel 12 wurde wiederholt mit der Ausnahme, daß die Lösung jetzt 6,8 Gt Poly-(dihydroxybenzidinisophthalamid) und 6,8 Gt der lichtempfindlichen Verbindung c) in 84,4 Gt N-Methylpyrrolidon enthält. Als Entwickler wurde unverdünnter AZ-Developer verwendet.

Folgende Ergebnisse wurden erhalten:

Lichtempfindlichkeit: 364 mJ/cm$^2$

Abtrag: 0,007 µm/

Die folgende Tabelle 2 faßt noch einmal die Ergebnisse der vorliegenden Beispiele zusammen.

Tabelle 2

| Beispiel | Lichtempfindlichkeit (mJ/cm$^2$) | |
|---|---|---|
| 5 | 76,4 | |
| 6 | 74,8 | |
| 7 | 65,0 | |
| 8 | 81,0 | Erfindung |
| 9 | 77,6 | |
| 10 | 199,5 | |
| 11 | 237,9 | |
| 12 | 589 | Stand der |
| 13 | 364 | Technik |

Die folgenden zusätzlichen Beispiele wurden durchgeführt, um die vorteilhaften Eigenschaften der erfindungsgemäßen Polyamide auf dem Gebiet der Lithographie zu verdeutlichen. In diesen Beispielen wurde das Verhältnis von Polyamid zu lichtempfindlicher Verbindung variiert. Die folgende generelle Vorgehensweise wurde in diesen Beispielen eingehalten.

Das Polyamid und die lichtempfindlichen Verbindungen wurden in einem Lösungsmittel gelöst und im "roller-coat"-Verfahren auf einen anodisierten Aluminiumträger aufgebracht. Das Lösungsmittel wurde durch Trocknen der Schicht bei 90° C entfernt, zurück blieb eine lichtempfindliche Schicht einer Dicke von 2-3 µm.

Die lichtempfindliche Schicht wurde mit einer GATF-Photomaske zur Ermittlung der Lichtempfindlichkeit bedeckt, die einen 21stufigen Halbtonkeil mit Dichtestufen zu je 0,15 enthielt. Die Ausführungen können dem GATF Research Bulletin 215 entnommen werden.

Das lichtempfindliche Aufzeichnungsmaterial wurde durch die GATF-Photomaske mit UV-Licht belichtet, mit einem wäßrig-alkalischen Entwickler belichtet. Die ermittelten Werte bezüglich Belichtungszeit, Lichtempfindlichkeit, Entwicklerkonzentration, Entwicklungszeit und das Verhältnis von Polyamid zur lichtempfindlichen Verbindung sind in den folgenden Beispielen und in der Tabelle 3 zusammengefaßt.

Die in den Beispielen genannten Polyamide wurden entsprechend den Vorschriften aus Beispiel 1 hergestellt.

Beispiel 14

Es wurde das Polykondensationsprodukt aus Hexafluor-2,2-bis(3-amino-4-hydroxyphenyl)-propan und Terephthaloylchlorid hergestellt.

Beispiel 15

Es wurde das Polykondensationsprodukt aus Hexafluor-2,2-bis(3-amino-4-hydroxyphenyl)-propan und Isophthaloylchlorid hergestellt.

Beispiel 16

Es wurde das Polykondensationsprodukt aus Hexafluor-2,2-bis(3-amino-4-hydroxyphenyl)-propan und Hexafluor-2,2-bis(4-chlorcarbonylphenyl)-propan hergestellt.

Beispiel 17

Es wurde das Polykondensationsprodukt aus Hexafluor-2,2-bis(3-amino-4-hydroxyphenyl)-propan und einer äquimolaren Mischung aus Hexafluor-2,2-bis(4-chlorcarbonylphenyl)propan und Isophthaloylchlorid hergestellt.

Mit den in den Beispielen 1, 14, 15, 16 und 17 beschriebenen Polyamiden wurden lichtempfindliche Gemische hergestellt, jeweils mit der lichtempfindlichen Verbindung a), in einem Lösungsmittelgemisch aus 60 Gew.-% Methylethylketon und 40 Gew.-% Propylenglykolmethylether.

Nach Belichtung mit UV-Licht einer Wellenlänge von 365 nm für 90 s wurde mit einem AZ-Developer, gelöst in einem Teil Wasser, entwickelt. Der Feststoffgehalt in jedem Beispiel (Polyamid und lichtempfindliche Verbindung) war 10 Gew.-%.

Tabelle 3

| Polyamid | Verhältnis Polyamid/lichtempfindliche Verbindung | Keilstufen | Lichtempfindlichkeit |
|---|---|---|---|
| Beispiel 1 | 1:1 | 7 | gut |
| | 6:1 | 21 | schnell |
| Beispiel 14 | 1:1 | 4 | langsam |
| | 6:1 | 21 | schnell |
| Beispiel 15 | 1:1 | 21 | schnell |
| | 6:1 | 21 | schnell |
| Beispiel 16 | 1:1 | 2 | langsam |
| | 6:1 | 6 | gut |
| Beispiel 17 | 1:1 | 7 | gut |
| | 6:1 | 21 | schnell |

Die oben aufgeführten Werte lassen erkennen, daß die Lichtempfindlichkeit durch Variation des Verhältnisses Polyamid zu lichtempfindlicher Verbindung kontrolliert werden kann. Die lichtempfindlichkeit basierend auf dem lichtempfindlichen Gemisch nach Beispiel 16 ist extrem hoch, das lichtempfindliche Gemisch nach Beispiel 18 dagegen zeigt die beste Auflösung und die beste Haftung der Schicht auf dem Träger.

Beispiel 18

Das Polyamid des Beispiels 16 wurde in einer lichtempfindlichen Mischung eingesetzt, in der als Lösungsmittel eine Mischung aus 10 Gew-% Methylethylketon und 90 Gew-% Propylenglykolmethylether eingesetzt wurde. Entsprechend den Angaben in den Beispielen 14 bis 17 wurden die Keilstufen in Abhängigkeit verschiedener Verhältnisse von Polyamid zu lichtempfindlicher Verbindung ermittelt.

Folgende Ergebnisse wurden erhalten:

| Verhältnis Polyamid zu lichtempfindlicher Verbindung | Keilstufe |
|---|---|
| 1:1 | 3 |
| 2:1 | 5 |
| 3:1 | 6 |
| 4:1 | 6 |
| 5:1 | 7 |
| 6:1 | 7 |

Die Haftung der lichtempfindlichen Schicht auf dem Aluminiumträger war sehr gut, beinhaltend, daß dieses Polyamid auch eine gute Schutzschicht in anderen, nicht auf dem Gebiet der Photoresists liegenden Fällen zeigen dürfte.

**Patentansprüche**

**1.** Polyamid, geeignet als Bindemittel für positiv arbeitende lichtempfindliche Gemische, dadurch gekennzeichnet, daß es der allgemeinen Formel I

$$\left[ (NH\text{-}X\text{-}NH)_a - (CO\text{-}Y\text{-}CO)_b - (NH\text{-}Z\text{-}NH)_c - (CO\text{-}Y\text{-}CO)_d \right]_n \qquad (I)$$

entspricht, worin

X eine zweiwertige Gruppe der Formel

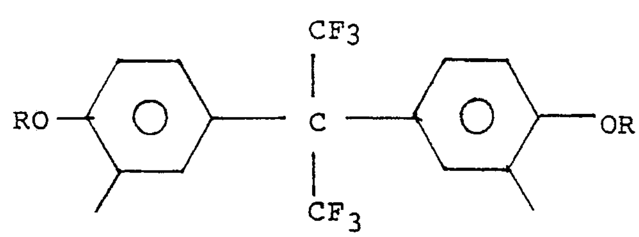

worin R gleich oder verschieden sein kann und Wasserstoff, einen ggf. substituierten aliphatischen oder aromatischen Rest mit bis zu 9 C-Atomen,

Y und Z gleich oder verschieden sind und einen ggf. substituierten aliphatischen, aromatischen

oder cycloaliphatischen Rest mit bis zu 60 C-Atomen sowie Mischungen dieser,

a 0,10 bis 0,50 Molanteile,

b 0,25 bis 0,50 Molanteile,

c 0,0 bis 0,40 Molanteile und

d 0,0 bis 0,25 Molanteile, jeweils bezogen auf das Gesamtmolekulargewicht aus X + Y + Z, wobei a + b + c + d = 1 gilt und

n eine ganze Zahl von 2 bis 500

bedeuten.

2. Polyamid nach Anspruch 1, dadurch gekennzeichnet, daß

Y, Z gleich oder verschieden sein können und Methylen, Difluormethylen, Polydifluormethylen mit 2 bis 12 C-Atomen, ein ggf. substituiertes Polymethylen mit 2 bis 12 C-Atomen, Cyclohexylen, Cyclohexenylen, Piperazinylen, Arylen, Biarylen, Naphthylen oder ein Polyarylen nach Formel II

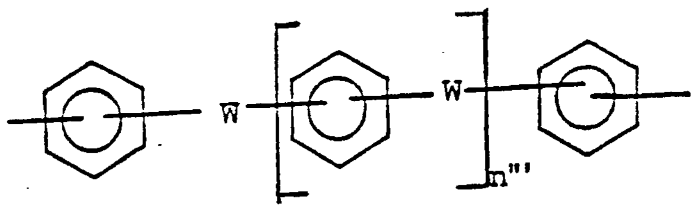

(II)

bedeuten, wobei

W das Bindeglied bildende Gruppe, jeweils eine der folgenden Gruppen sein kann: eine einfache C-C-Bindung; eine Methylengruppe; eine Polymethylengruppe mit 2 bis 12 C-Atomen; eine Difluormethylengruppe; eine Polydifluormethylengruppe mit 2 bis 12 C-Atomen, eine Hexafluorisopropylidengruppe; eine Isopropylidengruppe; eine Oxy- oder Thiogruppe; eine Sulfinylgruppe; eine Sulfonylgruppe; eine Sulfonyldioxygruppe; eine Sulfonamidogruppe; eine Carbonylgruppe oder eine der folgenden Gruppen:

$-(O-SiA_2-O)_{n'}-$ ; $-SiA_2-$

$-SiA_2-O-SiA_2-$ ; 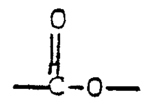

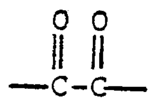 ; 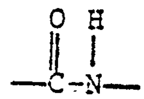

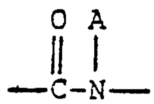 ; 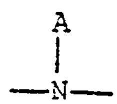

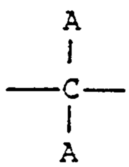 ; 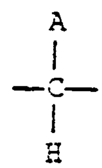

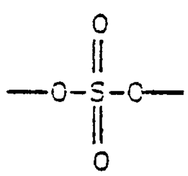 ; 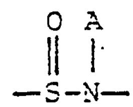

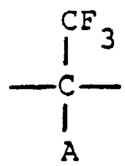

;

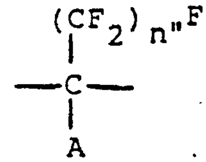

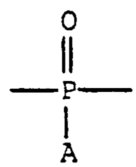

;

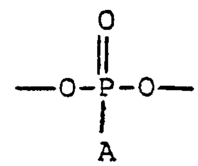

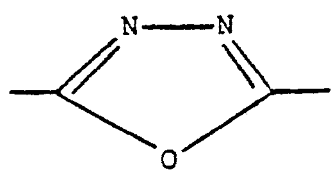

;

$-D-(CH_2)_{n''}-D-$;

$-(CH_2)_{n''}-D-(CH_2)_{n''}-$ ;

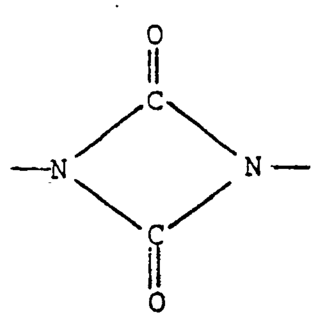

eine Cyclohexylengruppe; eine Cyclohexenylengruppe; eine Naphthylengruppe, sowie Mischungen daraus.

A kann jeweils eine substituierte oder unsubstituierte Alkylgruppe mit 1 bis 8 C-Atomen; eine substituierte oder unsubstituierte Phenylgrupe oder eine substituierte oder unsubstituierte Naphthylgruppe bedeuten.

D kann jeweils eine der folgenden Gruppen bedeuten: eine Oxygruppe; eine Thiogruppe; eine Carbonylgruppe; eine Oxycarbonylgruppe; eine Sulfonamidogruppe; eine Sulfinylgruppe; eine

Sulfonylgruppe; eine Sulfonyldioxygruppe; eine Benzoldicarbonylgruppe; oder eine der folgenden Gruppen:

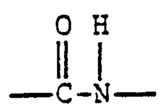 ; 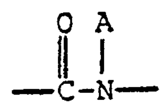 und

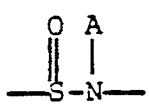 ; 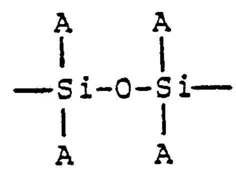

n' bedeutet eine ganze Zahl von 1 bis 25,
n" eine ganze Zahl von 1 bis 12 und
n"' eine ganze Zahl von 0 bis 3, mit der Maßgabe, daß W keine C-C-Einfachbindung darstellt, wenn n"' = 0 ist.

**3.** Polyamid nach den Ansprüchen 1 oder 2, dadurch gekennzeichnet, daß a 0,25 bis 0,5 Molanteilen entspricht.

**4.** Polyamid nach einem oder mehreren der Ansprüche 1 bis 3, dadurch gekennzeichnet, daß Y und/oder Z jeweils zu mindestens 70 Mol-% aus aromatischen zweiwertigen Gruppen oder Mischungen derselben bestehen.

**5.** Polyamid nach einem oder mehreren der Ansprüche 1 bis 4, dadurch gekennzeichnet, daß Y und/oder Z ein Gemisch aus m-Phenylen-, p-Phenylen- oder Hexafluor-2,2-bis-(p-phenyl)propangruppen darstellt.

**6.** Positiv arbeitendes lichtempfindliches Gemisch, im wesentlichen bestehend aus einem o-Chinondiazid und einem in wäßrig-alkalischer Lösung löslichen Bindemittel, dadurch gekennzeichnet, daß als Bindemittel ein Polyamid gemäß einem oder mehreren der Ansprüche 1 bis 5 enthalten ist.

**7.** Lichtempfindliches Gemisch nach Anspruch 6, dadurch gekennzeichnet, daß es zusätzlich ein Lösungsmittel enthält.

**8.** Lichtempfindliches Gemisch nach den Ansprüchen 6 oder 7, dadurch gekennzeichnet, daß das o-Chinondiazid ein (Misch)ester einer Phenolverbindung mit mindestens zwei Hydroxylgruppen ist.

**9.** Lichtempfindliches Aufzeichnungsmaterial, im wesentlichen bestehend aus einem Träger und einer lichtempfindlichen Schicht, dadurch gekennzeichnet, daß als lichtempfindliche Schicht eine gemäß einem oder mehreren der Ansprüche 6 bis 8 enthalten ist.

**10.** Lichtempfindliches Aufzeichnungsmaterial nach Anspruch 9, dadurch gekennzeichnet, daß es nach bildmäßiger Belichtung und anschließendem Entwickeln bei Temperaturen um 250 °C wärmebehandelt ist.

## Claims

**1.** Polyamide, suitable as a binder for positive-working light-sensitive mixtures, characterised in that it is of the general formula I

$$-\left[(NH-X-NH)_a-(CO-Y-CO)_b-(NH-Z-NH)_c-(CO-Y-CO)_d\right]_n-$$

in which

X is a divalent group of the formula

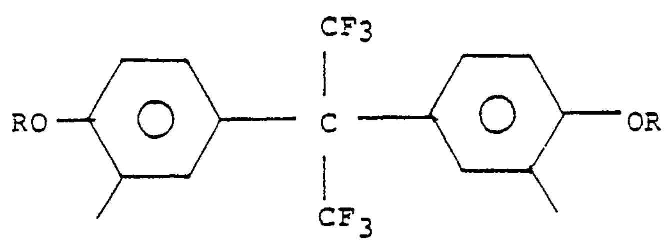

in which the R can be identical or different and are hydrogen or an optionally substituted aliphatic or aromatic radical having up to 9 carbon atoms,

Y and Z are identical or different and are an optionally substituted aliphatic, aromatic or cycloaliphatic radical having up to 60 carbon atoms, or mixtures thereof,

a represents a mole fraction of 0.10 to 0.50,

b represents a mole fraction of 0.25 to 0.50,

c represents a mole fraction of 0.0 to 0.40 and

d represents a mole fraction of 0.0 to 0.25, each relative to the total molecular weight of X + Y + Z, with $a+b+c+d=1$, and

n is an integer from 2 to 500.

**2.** Polyamide according to Claim 1, characterised in that

Y and Z can be identical or different and are methylene, difluoromethylene, polydifluoromethylene having 2 to 12 carbon atoms, an optionally substituted polymethylene having 2 to 12 carbon atoms, cyclohexylene, cyclohexenylene, piperazinylene, arylene, biarylene, naphthylene or a polyarylene according to formula II

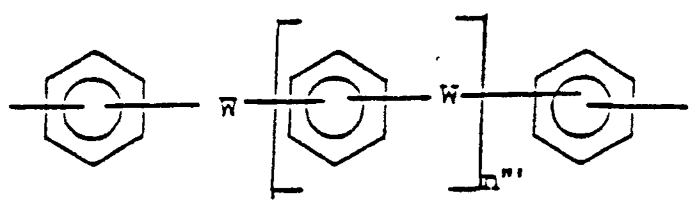

wherein

W, the group forming the linking member, can in each case be one of the following groups: a single C-C bond; a methylene group; a polymethylene group having 2 to 12 carbon atoms; a difluoromethylene group; a polydifluoromethylene group having 2 to 12 carbon atoms; a hexafluoroisopropylidene group; an isopropylidene group; an oxy group or thio group; a sulphinyl group; a sulphonyl group; a sulphonyldioxy group; a sulphonamido group; a carbonyl group or one of the following groups:

$—(O-SiA_2-O)_{n'}—$ ; $—SiA_2—$

$—SiA_2—O-SiA_2—$ ; 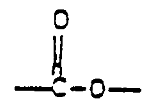

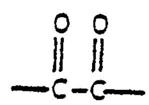 ; 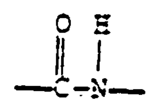

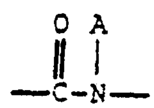 ; 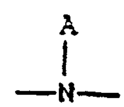

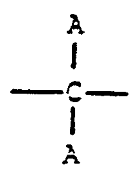 ; 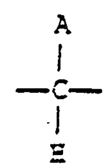

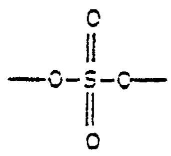 ; 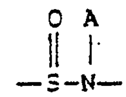

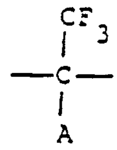 ; 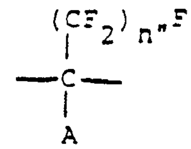

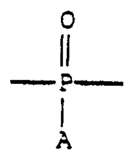 ; 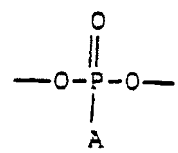

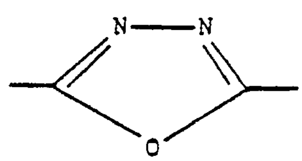 ;

$-D-(CH_2)_{n''}-D-$;

$-(CH_2)_{n''}-D-(CH_2)_{n''}-$ ;

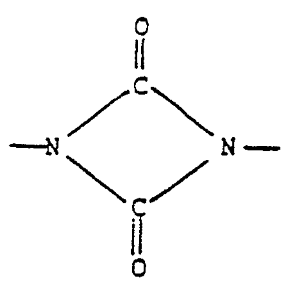

a cyclohexylene group; a cyclohexenylene group; a naphthylene group, or mixtures thereof,

A can in each case be a substituted or unsubstituted alkyl group having 1 to 8 carbon atoms; a substituted or unsubstituted phenyl group or a substituted or unsubstituted naphthyl group;

D can in each case be one of the following groups: an oxy group; a thio group; a carbonyl group; an oxycarbonyl group; a sulphonamido group; a sulphinyl group; a sulphonyl group; a

sulphonyl dioxy group; a benzene dicarbonyl group; or one of the following groups:

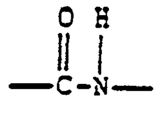 ; 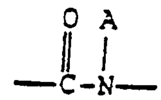 ;

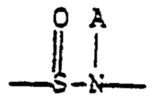 and 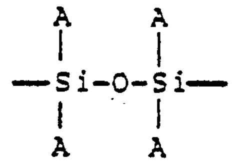

n' is an integer from 1 to 25,
n" is an integer from 1 to 12 and
n"' is an integer from 0 to 3, with the proviso that W is not a C-C single bond if n"' = 0.

3. Polyamide according to Claim 1 or 2, characterised in that a corresponds to a mol fraction of 0.25 to 0.5.

4. Polyamide according to one or more of Claims 1 to 3, characterised in that Y and/or Z consist in each case of at least 70 mol % of aromatic divalent groups or mixtures thereof.

5. Polyamide according to one or more of Claims 1 to 4, characterised in that Y and/or Z are a mixture of m-phenylene groups, p-phenylene groups or hexafluoro-2,2-bis-(p-phenyl)-propene groups.

6. Positive-working light-sensitive mixture, essentially consisting of an o-quinone-diazide and a binder soluble in an aqueous-alkaline solution, characterised in that the polyamide according to one or more of Claims 1 to 5 is present as the binder.

7. Light-sensitive mixture according to Claim 6, characterised in that it additionally contains a solvent.

8. Light-sensitive mixture according to Claim 6 or 7, characterised in that the o-quinone-diazide is a (mixed) ester of a phenol compound having at least two hydroxyl groups.

9. Light-sensitive recording material, essentially consisting of a support and a light-sensitive layer, characterised in that the light-sensitive layer is a layer according to one or more of Claims 6 to 8.

10. Light-sensitive recording material according to Claim 9, characterised in that, after imagewise exposure and subsequent development, it is heat-treated at temperatures of around 250 °C.

**Revendications**

1. Polyamide, approprié en tant que liant pour compositions photosensibles travaillant en positif, caractérisé en ce qu'il correspond à la formule générale I

$$\left[ (NH\text{-}X\text{-}NH)_a - (CO\text{-}Y\text{-}CO)_b - (NH\text{-}Z\text{-}NH)_c - (CO\text{-}Y\text{-}CO)_d \right]_n \quad (I)$$

dans laquelle
X représente un groupe bivalent de formule

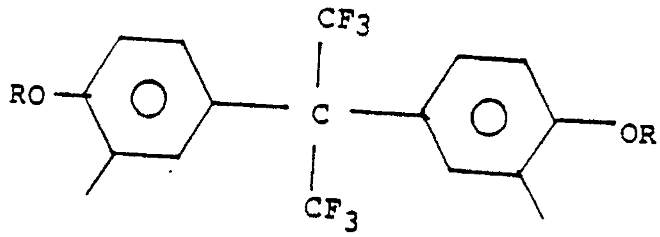

dans laquelle les radicaux R peuvent être identiques ou différents et représentent un atome d'hydrogène ou un radical aliphatique ou aromatique éventuellement substitué, ayant jusqu'à 9 atomes de carbone,

Y et Z sont identiques ou différents et représentent un radical aliphatique, aromatique ou cycloaliphatique éventuellement substitué, ayant jusqu'à 60 atomes de carbone, ainsi que des mélanges de ceux-ci,

a représente de 0,10 à 0,50 partie en mole,

b représente de 0,25 à 0,50 partie en mole,

c représente de 0,0 à 0,40 partie en moles et

d représente de 0,0 à 0,25 partie en mole, dans chaque cas par rapport à la masse moléculaire totale de X + Y + Z, a + b + c + d étant égal à 1, et

n représente un nombre entier allant de 2 à 500.

**2.** Polyamide selon la revendication 1, caractérisé en ce que

Y, Z peuvent être identiques ou différents et représentent le groupe méthylène, difluorométhylène, un groupe polydifluorométhylène ayant de 2 à 12 atomes de carbone, un polyméthylène éventuellement substitué ayant de 2 à 12 atomes de carbone, un groupe cyclohexylène, cyclohexénylène, pipérazinylène, arylène, biarylène, naphtylène ou un groupe polyarylène de formule II

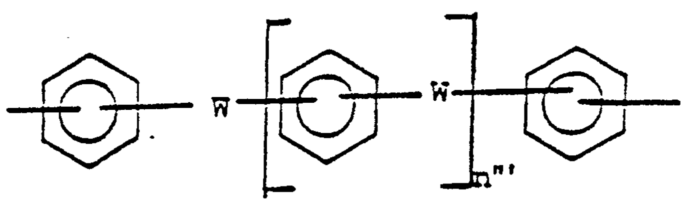

(II)

W, groupe formant le chaînon de liaison, pouvant être respectivement un des groupes suivants: une simple liaison C-C, un groupe méthylène, un groupe polyméthylène ayant de 2 à 12 atomes de carbone, un groupe difluorométhylène, un groupe polydifluorométhylène ayant de 2 à 12 atomes de carbone, un groupe hexafluoroisopropylidène, un groupe isopropylidène, un groupe oxy ou thio, un groupe sulfinyle, un groupe sulfonyle, un groupe sulfonyldioxy, un groupe sulfonamido, un groupe carbonyle ou l'un des groupes suivants:

$-(O-SiA_2-O)_{n'}-$ ; $-SiA_2-$

$-SiA_2-O-SiA_2-$ ; 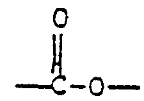

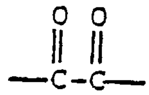 ; 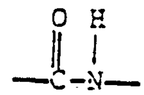

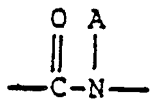 ; 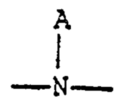

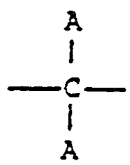 ; 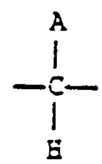

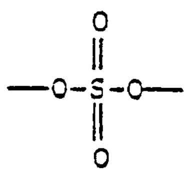 ; 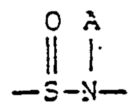

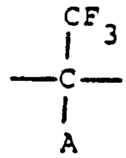 ; 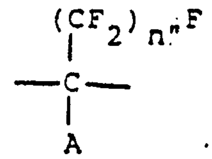 .

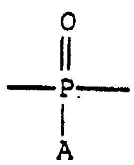 ; 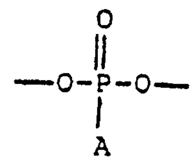

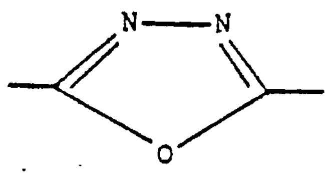 ;

$-D-(CH_2)_{n''}-D-$ ;

$-(CH_2)_{n''}-D-(CH_2)_{n''}-$ ;

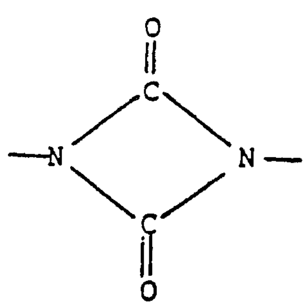

un groupe cyclohexylène, un groupe cyclohexénylène, un groupe naphtylène, ainsi que des mélanges de ceux-ci,

A pouvant représenter dans chaque cas un groupe alkyle substitué ou non substitué ayant de 1 à 8 atomes de carbone, un groupe phényle substitué ou non substitué ou un groupe naphtyle substitué ou non substitué,

D pouvant représenter dans chaque cas l'un des groupes suivants: un groupe oxy, un groupe

thio, un groupe carbonyle, un groupe oxycarbonyle, un groupe sulfonamido, un groupe sulfinyle, un groupe sulfonyle, un groupe sulfonyldioxy, un groupe benzènedicarbonyle, ou l'un des groupes suivants:

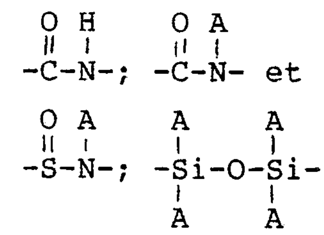

n' représente un nombre entier allant de 1 à 25,

n" représente un nombre entier allant de 1 à 12 et

n'" représente un nombre entier allant de 0 à 3, étant entendu que W ne représente pas une simple liaison C-C lorsque n'" = 0.

**3.** Polyamide selon la revendication 1 ou 2, caractérisé en ce que a correspond à 0,25-0,5 partie en mole.

**4.** Polyamide selon une ou plusieurs des revendications 1 à 3, caractérisé en ce que Y et/ou Z consistent chacun, à raison d'au moins 70 % en moles, en des groupes aromatiques divalents ou des mélanges de ceux-ci.

**5.** Polyamide selon une ou plusieurs des revendications 1 à 4, caractérisé en ce que Y et/ou Z représente(nt) un mélange de groupes m-phénylène, p-phénylène ou hexafluoro2,2-bis(p-phényl)-propane.

**6.** Composition photosensible travaillant en positif, essentiellement constituée d'un o-quinonediazide et d'un liant soluble dans une solution aqueuse-alcaline, caractérisée en ce qu'un polyamide selon une ou plusieurs des revendications 1 à 5 est contenu en tant que liant.

**7.** Composition photosensible selon la revendication 6, caractérisée en ce qu'elle contient en outre un solvant.

**8.** Composition photosensible selon la revendication 6 ou 7, caractérisée en ce que le o-quinonediazide est un ester (mixte) d'un composé phénolique comportant au moins deux groupes hydroxy.

**9.** Matériau de reproduction photosensible, essentiellement constitué d'un support et d'une couche photosensible, caractérisé en ce qu'une composition selon une ou plusieurs des revendications 6 à 8 est contenue en tant que couche photosensible.

**10.** Matériau de reproduction photosensible selon la revendication 9, caractérisé en ce qu'après insolation selon uneimage et développement subséquent, il est traité thermiquement à des températures d'environ 250 °C.